# EUROPEAN PATENT APPLICATION

(11) **EP 4 184 249 A1**
(43) Date of publication of application: **24.05.2023**
(21) Application number: 21209075.7
(22) Date of filing: 18.11.2021
(51) Int. Cl.: G03F 7/20

(54) **FINAL-STAGE OPTICAL FREQUENCY UP-CONVERSION IN PHOTO-LITHOGRAPHIC SYSTEMS**

(71) Applicant: MYCRONIC AB, 183 03 Täby (SE)
(72) Inventor: Jonsson, Fredrik, 114 58 Stockholm (SE)
(74) Representative: AWA Sweden AB

(57) **Abstract**

An optical system (1) comprises a light source (2) for emitting light at a first wavelength (λ₁), a scanning optical system (6) for sweeping a beam of light emitted from the light source, a light modulator (4) for changing the optical intensity of the beam during the scanning, an optical frequency up-conversion module (14) for converting light from the scanning optical system (6) at the first wavelength (λ₁) to light at a second wavelength (λ₂) which is shorter than the first wavelength (λ₁), and an exposure module (10) for imaging the light at the second wavelength (λ₂) onto a photosensitive material (12).

## Description

### Background

Frequency up-conversion, where light of lower wavelength is converted to shorter wavelengths, has been around since 1962, but for lithographic purposes it has been used primarily as a way of providing a source of light at an up-converted frequency which is then input into further optical modulation systems. In general, light of shorter wavelengths is desirable in optical micro-lithography due to the possibility of decreasing the size of a diffraction-limited spot of exposure, hence enabling smaller features to be written.

However, using light at ever shorter wavelengths in photo-lithographic systems leads to a higher degradation in any optical components exposed to ultra-violet (UV) light, and a considerably higher resulting absorption in optical components such as lenses, modulators, and deflectors when compared to lower frequency light. Also, a significant draw-back in acousto-optical scanning systems is a decreased acousto-optical efficiency.

Hence, there is a need to improve the handling of UV light in photo-lithographic systems such that light at increasingly higher frequencies can be provided via frequency up-conversion, without compromising the performance of imaging and modulation systems for the spatial shaping of light for exposure of photoresist micro-lithographic masks.

### Summary

In order to address this problem, a first aspect of the present disclosure provides an optical system, comprising a light source for emitting light at a first wavelength, a scanning optical system for sweeping a beam of light emitted from the light source and a light modulator for changing the optical intensity of the beam during the scanning. Therein, the light source may be a laser and the first wavelength may e.g. be a wavelength in the visible or near-UV range. According to the first aspect, the optical system further comprises an optical frequency up-conversion module for converting light from the scanning optical system at the first wavelength to light at a second wavelength which is shorter than the first wavelength and an exposure module for imaging the light at the second wavelength onto a photosensitive material.

Thus, instead of using a light source operating at a short wavelength throughout the optical train from the laser to the photoresist, the present disclosure provides an optical system wherein light at a longer wavelength is used throughout the optical train of a lithographic system, until a very late stage, such as immediately before the projection of the beam onto the photosensitive substrate, wherein the frequency of the light is up-converted in order to be able to generate smaller diffraction-limited spatial structures on the substrate using the short wavelength light. Typically, the modulation of intensity would be performed prior to the scanning of the beam of light.

According to embodiments, the scanning optical system may include relay optics to image light at the first wavelength onto a focal point or focal region, and the optical frequency up-conversion module may be positioned substantially at the focal point or focal region of the scanning optical system. Thereby, an optical frequency-mixing or sum-generation scheme can be efficiently carried out with the assistance of a supplied pump or mixing beam that is extracted from the original light source. The frequency up-conversion can then take place at a plane which is optically conjugate to the plane where the spatial deflection or spatial modulation is taking place.

The scanning optical system may comprise an acousto-optical modulator for providing temporal modulation to the light at the first wavelength. Therein, the scanning optical system may be configured to produce multiple, temporally modulated beams, e.g. by the use of a beam splitter or diffractive element or by the use of an array of modulators simultaneously supplying a plurality of beams.

According to embodiments, the optical frequency up-conversion module may comprise a non-linear optical crystal for generating a second or higher harmonic of the frequency of the incident light at the first wavelength in order to produce the light at the second wavelength. Thus, using light at the first wavelength as generated by the light source, light at a UV frequency can be generated for imaging onto the photosensitive substrate.

According to embodiments, the optical system may further comprise a light source for emitting light at a third wavelength. The light at the third wavelength may then be provided to the optical frequency up-conversion module, wherein the optical frequency up-conversion module comprises a non-linear optical crystal for generating a sum frequency of light at the first wavelength and light at the third wavelength in order to produce light at the second wavelength. Thus, exposure light at a desired second wavelength can be provided using a suitable mix between the first and third wavelengths in order to generate spatial structures at a desired diffraction-limited spatial resolution on the photosensitive substrate.

According to embodiments, the optical system may further comprise a beam expander module for shaping the light at the third wavelength such that the light at the third wavelength is incident on an area of the optical frequency up-conversion module which overlaps the focal point or focal region onto which light at the first wavelength is imaged. Thus, it can be ensured that the scanned light at the first wavelength is fully overlapped with light at the third wavelength at the focal point or focal region of the relay optics, so that frequency up-conversion using a sum frequency of the light at the first wavelength and the light at the third wavelength can take place in an efficient manner.

Therein, the light at the first wavelength and the light at the third wavelength may be emitted by a common light source to ensure mutual optical coherence between the beams. The light at the third wavelength may e.g. be generated by frequency up-conversion of a portion of the light at the first wavelength within the light source.

According to a further embodiment, an optical pattern generator is provided, which comprises the optical system as described above, and which further comprises a control module for controlling the scanning optical system and the light modulator; and a support structure for carrying the photosensitive material. Such a system for optical pattern generation typically comprises a beam splitter or diffractive element to split the beam into a plurality of individual scanning beams, transducers generating acoustic frequencies in radio ranges together with control electronics for the means of altering the generated frequencies to scan and attenuate individual beams to achieve spatial and temporal modulation resulting in a pattern exposing the photosensitive material.

According to a further aspect, the present disclosure provides a lithography exposure method, wherein light is provided at a first wavelength, the light at the first wavelength is modulated by a scanning beam and the optical intensity of the light at the first wavelength is changed during the modulation using a scanning optical system. Subsequently, the light output by the scanning optical system is converted to light at a second wavelength which is shorter than the first wavelength, and the light at the second wavelength is imaged onto a photosensitive material. Thus, as discussed above for the optical system according to the first aspect, the modulation and scanning steps can be performed using light at the longer first wavelength, thus significantly increasing the efficiency and reducing the degradation of the scanning and modulating optical components as well as lenses, beam splitters and other optical components. Before imaging onto the photosensitive material, light is then finally converted to a second, short wavelength, enabling a smaller diffraction-limited spot of exposure for the scanning beam or beams, so that structures at a higher spatial resolution can be generated on the photosensitive material.

According to embodiments, the method may further comprise imaging the light output by the scanning optical system onto a focal point and converting the scanned beam of light at the first wavelength to light at the second wavelength at the focal point. Thus, the frequency up-conversion can take place at the optically conjugate plane to the plane where the scanning is originating, hence ensuring that the resulting spatially modulated pattern as projected onto the photo-sensitive material is completely and undistortedly converted to a corresponding pattern of the light beam at the second wavelength.

According to embodiments, converting the scanned beam of light at the first wavelength to light at a second wavelength may comprise generating a second or higher harmonic of the light at the first wavelength. In this respect, it is to be noted that, throughout the present disclosure, any mentioning of "scanned beam" is to include one or multiple scanned beams for a system wherein a beam splitter or diffractive element is used to split a beam into a plurality of individual scanning beams. Alternatively, converting the scanned beam of light at the first wavelength to light at a second wavelength may comprise generating a sum frequency of the light at the first wavelength and of light at a third wavelength. Thus, light at a desired second wavelength can be generated either by selecting a suitable light source which provides light at a first wavelength that can be converted to light at the desired second wavelength by generation of a suitable harmonic frequency, or by generating light at suitable first and third wavelengths such that the sum frequency thereof provides light at the desired second wavelength.

According to embodiments, spatially modulating the light may comprise scanning of the beam by an acousto-optic modulator. Since the spatial modulation is performed on light at the first wavelength, a high efficiency of the acousto-optic modulator can be achieved, since it is operated using light at a comparatively long wavelength, which in addition ensures low optical absorption.

### Detailed Description

In the attached drawings, example optical systems are shown as a non-limiting illustration of selected aspects of the prior art and of the embodiments of the present disclosure. Therein:
- Fig. 1: shows a prior art photo-lithographic system which uses frequency up-conversion to generate UV light in the classical sense where the UV light is propagated and modulated throughout the optical train;
- Fig. 2: shows a first embodiment of an optical system in which the light at the first wavelength is up-converted by second (SHG) or third (THG) harmonic generation in a plane conjugate to the plane where the scanning is originating;
- Fig. 3: shows a second embodiment of an optical system in which the light at the first wavelength is up-converted by sum frequency generation (SFG) in a plane conjugate to the plane where the scanning is originating; and
- Fig. 4: shows an example of an optical pattern generator comprising the optical system according to the first or the second embodiment.

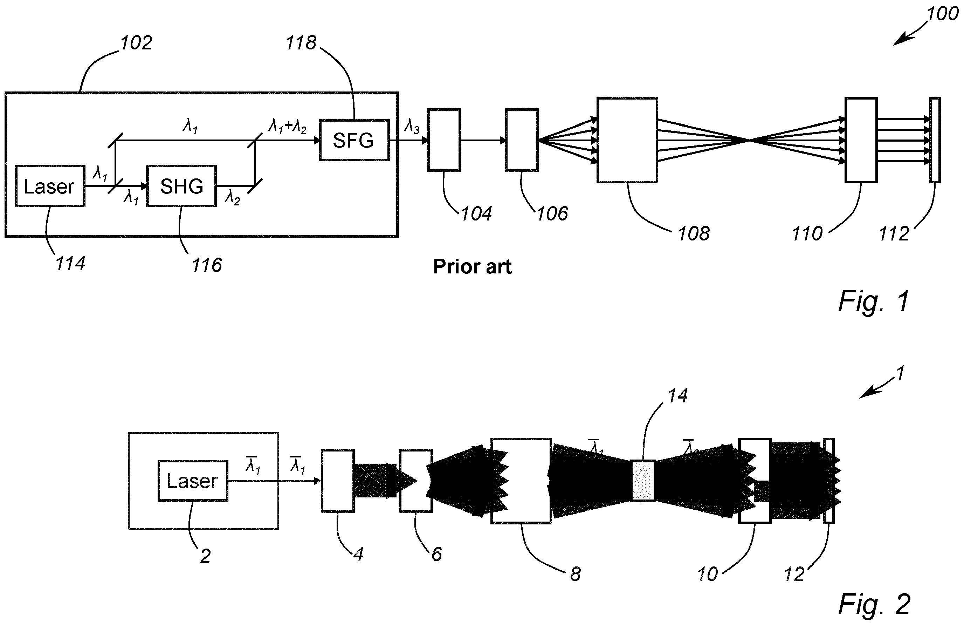

As shown in Fig. 1, in a known optical system 100, a light source 102 is provided which outputs light at an output wavelength λ₃. The output light beam is then temporally modulated at a modulator 104 providing intensity modulation, and provided to a scanning deflector 106 for providing a scanning light pattern of the spatially modulated light. The scanning beam as output by the scanning deflector 106 is provided to a relay optics module 108 and is imaged, using an imaging system 110, onto a photosensitive resist material 112. It is noted that, in this prior art system, the spatial modulation, scanning and optical relay stages are all performed on light at a wavelength λ₃, which is the same wavelength that is used for exposing the photosensitive resist 112. Typically, for achieving a sufficiently high spatial resolution of patterns on the photosensitive resist 112, the output wavelength λ₃ will with the capabilities of scanning pattern generators as of today be a UV wavelength in the range of 266 - 404 nm.

As further shown in Fig. 1, the output wavelength λ₃ may be generated in the light source 102 by converting the light at an initial wavelength λ₁ generated by a laser 114 to a higher frequency. Therein, a first frequency conversion module 116 may be used for generating light at a second wavelength λ₂ by generating a second harmonic frequency of the light emitted by the laser 114. Thus, the first frequency conversion module 116, to which light at an incident frequency ω₁ is input, generates light at a second harmonic frequency of ω₁ + ω₁ = ω₂. A second frequency conversion module 118 may further be provided in the light source for generating light at the output wavelength λ₃ by generating light at a sum frequency of the light emitted by the laser 114 at the initial wavelength λ₁ and light generated by the first frequency conversion module 116 at the second wavelength λ₂. Thus, the second frequency conversion module 118, to which light at the incident frequencies ω₁ and ω₂ is input, generates output light at the sum frequency ω₁ + ω₂ = ω₃.

However, with the optical system 100 of Fig. 1, the modulator 104, the scanning deflector 106 and the relay optics 108 are all subjected to UV light at the output wavelength λ₃. This leads to a fast deterioration and high absorbance of the various lenses, optically active crystals and other optical components of the modulator 104, the scanning deflector 106 and the relay optics 108.

Additionally, for future developments of further decreasing the output wavelength λ₃ in order to achieve ever higher spatial resolutions for patterning the photosensitive resist material 112, any optical components subjected to light at ever decreasing wavelengths may need to be redesigned. Also, there is a significant problem to find materials which in the UV regime allow for acceptable transparency meanwhile possessing desired properties such as high acousto-optical coefficients of their susceptibility tensors. These problems are particularly pronounced for modulation and scanning systems using the acousto-optical components, where a considerably shorter optical wavelength would not only increase optical absorption but also result in a lower acousto-optical coupling efficiency.

Thus, in order to improve the known optical system 100 as shown in Fig. 1, the present disclosure provides an optical system 1 according to a first embodiment as shown in Fig. 2. Therein, a laser light source 2 generates light at a first wavelength *λ*₁ which is subsequently supplied to a modulator 4, such as e.g. an acousto-optic modulator or a diffractive optical element, and a scanning deflector 6 such as e.g. an acousto-optic deflector. According to further modifications, other modulators 4, such as electrically or optically addressed modulators, may be used. Similarly, other scanning deflectors 6, such as electro-optic scanning deflectors, may be used.

Relay optics 8 are provided for focussing the modulated scanning beam onto a focal point. At the focal point, an optical frequency up-conversion module 14 is provided for converting light at the first wavelength *λ*₁ to light at a second wavelength *λ*₂, wherein the second wavelength is shorter than the first wavelength. The frequency up-conversion can be performed using a nonlinear optical crystal which can generate second, third or higher harmonics of the incident light at frequency ω₁, thus generating light at a second harmonic frequency of ω₁ + ω₁ = ω₂ or light at a third harmonic frequency of ω₁ + ω₁ + ω₁ = ω₂. In this manner, exposure wavelengths *̅λ̅*̅₂̅ of about 90 - 200 nm can be reached, with the advantage of employing longer wavelengths throughout the optical train in the scanning and modulation prior to the frequency conversion.

The up-converted light then enters an imaging system 10 and is imaged onto a photosensitive resist material 12.

Thus, according to the embodiment shown in Fig. 2, the optical modulator 4 and the scanning deflector 6 are subjected to light at the longer first wavelength *̅λ̅*̅₁̅ and only the imaging system and the photosensitive resist material 12 are exposed to light at the second, shorter wavelength *̅λ̅*̅₂̅. Thus, the modulating and scanning stages of the photolithographic system can be operated at a longer wavelength and frequency up-conversion can be performed at a final stage just before the light is imaged onto the photoresist material 12. The frequency conversion takes place in the optical plane conjugate to the scanning deflector 6, thus ensuring that the deflected beam is provided at the frequency up-conversion module 14 with a small beam diameter and high local intensity. Hence, according to the embodiment of Fig. 2, the scanning beam is imaged onto the optical frequency up-conversion plane as the focal point or the optically conjugate plane of the scanning deflector plane, and is then subsequently imaged onto the photosensitive resist 12.

Thus, a higher spatial resolution can be achieved for patterning the photosensitive resist material 12 due to the use of a shorter wavelength *̅λ̅*̅₂̅ for imaging, while the temporal modulation and scanning deflection of the beam can be performed at a higher efficiency of the respective optical components at the longer wavelength *̅λ̅*̅₁̅.

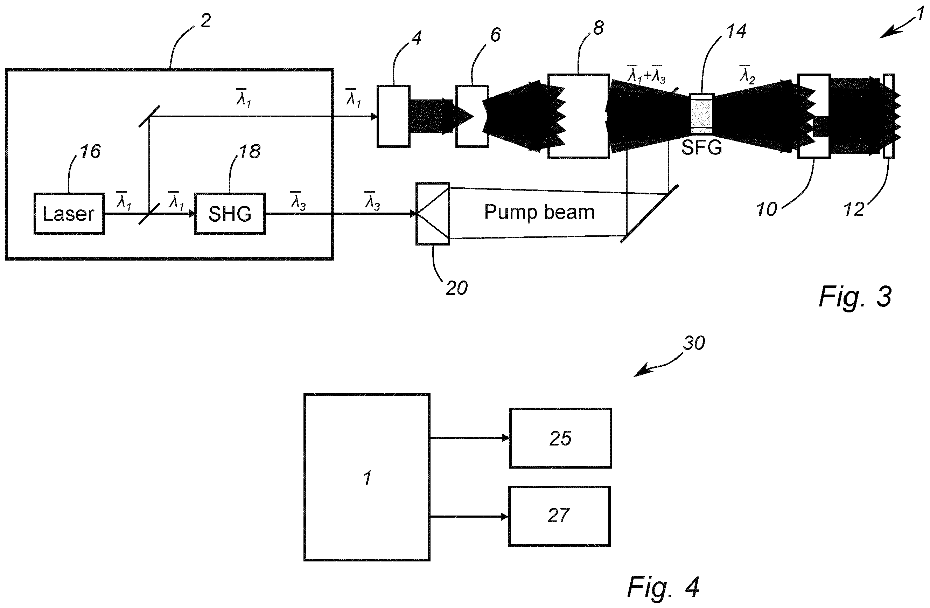

Fig. 3 shows a second embodiment of an optical system 1, wherein, instead of the laser light source 2 of the first embodiment which only produces light at the first wavelength *λ*₁, a composite light source 2 is provided, wherein a laser 16 generates light at the first wavelength *̅λ̅*̅₁̅ and wherein light at a third wavelength *λ*₃ is generated by a suitable method, such as e.g. generation of a second harmonic frequency of the laser light at the first wavelength *̅λ̅*̅₁̅ using a non-linear optical crystal 18. For light supplied to the non-linear optical crystal 18 at frequency ω₁, light at the second harmonic frequency ω₁ + ω₁ = ω₂ is generated.

The light at the third wavelength *λ*₃ is then supplied as a pump beam to the optical frequency up-conversion module 14 where a sum frequency of the light at the first wavelength *̅λ̅*̅₁̅ that is output from the relay optics 8 and the light at the third wavelength *λ*₃ provided from the light source 2 may be generated.

Therein, the pump beam at the third wavelength *̅λ̅*̅₃̅ may be expanded using a beam expander 20 and may be imaged onto the optical frequency up-conversion plane 14 such that fully overlaps the focal point of the relay optics 8 during a scanning cycle of the beam at wavelength *λ*₁. Thus, with light at a frequency of ω₁ supplied from the relay optics 8 and light at a frequency of ω₃ supplied by the pump beam, the optical frequency up-conversion module 14 generates light at a sum frequency of ω₁ + ω₃ = ω₂ which is then imaged onto the photosensitive material 12 using the imaging system 10.

For the first embodiment as shown in Fig. 2, the intensity of the lithographic beam output by the relay optics 8 needs to be sufficiently high to carry out second-harmonic or third-harmonic generation in the optical frequency up-conversion stage. just before the final projection down to the photoresist. In contrast, the pump beam provided by the beam expander 20 according to the second embodiment as shown in Fig. 3 can ensure that frequency up-conversion can be performed on the light at the first wavelength *λ*₁ that is output by the relay optics 8 even when the scanning lithographic beam may have a lower intensity that would not be sufficient for generation of second or higher harmonic frequencies.

Not shown in Figs. 2 or 3 are filters for removing any remains of the optical beams participating in the up-conversion. A person skilled in the art will appreciate that such filters may be inserted at suitable positions in the optical path in order to ensure that a clean UV beam, free from any longer wavelengths, is imaged onto the photosensitive resist material 12.

Since the scanning and deflection optical components are not exposed to the aggressive UV radiation at the up-converted frequency, the optical system 1 according to the above-described embodiments can be adapted to use considerably shorter optical wavelengths than prior art systems. For further decreasing the wavelengths of the light that is imaged onto the photosensitive material 12, only the frequency up-conversion module 14 and the imaging system 10 would have to be adapted, while the modulation and scanning components could remain unchanged. Hence, there is no need to redesign a set of highly specialized and expensive components for light at ever shorter UV wavelength, as for example diffractive optical elements (DOE), acousto-optical deflectors (AOD) or modulators (AOM).

Further, when a DOE is operated as a modulator 4 at the longer wavelength *̅λ̅*̅₁̅, the DOE will be less sensitive to any defects, as operation at a longer wavelength reduces the impact of imperfections. The AOD and AOM will be more efficient than at shorter wavelengths, as shorter optical wavelengths will be deflected less than longer ones at the same acoustic carrier frequency. Also, the heat generated by the AOD and AOD will be less compared to operation at higher acoustic carrier frequencies at the same modulation amplitude.

The life-time of any optical components used in the optical train before the frequency up-conversion module 14 will be longer, as there is no aggressive UV light present in the optical train up until just before the final projection stage. This leads to higher robustness and less cost for service and warranty. During the optical train before the frequency up-conversion module 14, mode cleaning of the optical beam through an optical fiber is possible, whereas optical fibers are typically not sufficiently transparent in the UV range in order to enable mode cleaning of UV light. Cameras and alignment tools for adjusting the modulation and scanning components provided before the frequency up-conversion module 14 are considerably cheaper when longer wavelengths are used in this portion of the optical train.

Due to the variety of frequency up-conversion paths, using either harmonics or sum frequencies with additional frequencies provided by pump beams, there is a much richer flora of light sources (lasers) to choose from.

Fig. 4 is a schematic illustration of an optical pattern generation system 30 which comprises an optical system 1 according to any of the embodiment as described above. The optical pattern generation system 30 further comprises a control module 25 for controlling the operation of components of the optical system 1, such as the modulator 4, the scanning deflector 6 and the like, and a support structure 27 for carrying the photosensitive material 12 that is being exposed to the modulated light at the second wavelength λ₂ by the optical system 1.

In summary, the above-disclosed embodiments thus make use of the comparatively long wavelength λ₁ for the beams that are being modulated and spatially deflected, with the benefit that well-proven and well-known optical components may be employed. Only in the final stage, just before the beams are projected to the photoresist 12, is the lithographic beam up-converted in frequency, compared to prior art systems where the short wavelength is generated inside the laser light source and supplied through the complete optical train of the photolithographic system.

Since it can be considered beneficial to have the optical frequency up-conversion taking place in a fixed and spatially limited spot, typically inside a nonlinear optical crystal, the plane of conversion may be optically conjugate to the plane where the beams are deflected. In other words, that the deflection plane is imaged onto the plane of up-conversion of frequency.

In summary, by applying the frequency conversion at a very late stage in the optical train, the embodiments of the present disclosure as described above ensure that modules which are UV-sensitive and/or highly absorbing at UV are not exposed to UV radiation, thus enabling a higher performance and a longer lifetime. By employing the same wavelength as today used in lithography, the possibility also opens up for decreasing the wavelength used when projecting the pattern down to the photoresist, which in turn is an enabler for a smaller spot size and hence a smaller feature size in the pattern. Also, another advantage is that acousto-optical elements such as the deflector (AOD) and modulator (AOM) maintains their acousto-optical efficiency, as a shorter wavelength would have meant severe implications due to the need for a higher acoustic carrier frequency, less coupling efficiency and a lower transparency.

## Claims

1. Optical system (1), comprising:
a light source (2) for emitting light at a first wavelength (λ₁);
a scanning optical system (6, 8) for sweeping a beam of light emitted from the light source (2);
a light modulator (4) for changing the optical intensity of the beam during the scanning;
an optical frequency up-conversion module (14) for converting light from the scanning optical system (6, 8) at the first wavelength (λ₁) to light at a second wavelength (λ₂) which is shorter than the first wavelength (λ₁); and
an exposure module (10) for imaging the light at the second wavelength (λ₂) onto a photosensitive material (12).

2. Optical system (1) according to claim 1, wherein the scanning optical system (6, 8) includes relay optics (8) to image light at the first wavelength (λ₁) onto a focal point or focal region, and wherein the optical frequency up-conversion module (14) is positioned substantially at the focal point or focal region of the scanning optical system (6, 8).

3. Optical system (1) according to any one of claims 1 or 2, wherein the scanning optical system (6, 8) and/or the light modulator (4) comprise an acousto-optical modulator.

4. Optical system (1) according to any one of claims 1 to 3, wherein the optical frequency up-conversion module (14) comprises a non-linear optical crystal for generating a second or higher harmonic of the frequency of the incident light at the first wavelength (λ₁) in order to produce the light at the second wavelength (λ₂).

5. Optical system (1) according to any one of claim 1 to 4, further comprising a light source (2) for emitting light at a third wavelength (λ₃), wherein the light at the third wavelength (λ₃) is provided to the optical frequency up-conversion module (14), wherein the optical frequency up-conversion module (14) comprises a non-linear optical crystal for generating a sum frequency of light at the first wavelength (λ₁) and light at the third wavelength (λ₃) in order to produce light at the second wavelength (λ₂).

6. Optical system (1) according to claim 5, further comprising a beam expander module (20) for shaping the light at the third wavelength (λ₃) such that the light at the third wavelength (λ₃) is incident on an area of the optical frequency up-conversion module (14) which overlaps the focal point onto which light at the first wavelength (λ₁) is imaged.

7. Optical system (1) according to claim 6, wherein the light at the first wavelength (λ₁) and the light at the third wavelength (λ₃) are emitted by a common light source (2).

8. Optical pattern generator (30), comprising the optical system (1) according any one of claims 1 to 7, the optical pattern generator (30) further comprising:
a control module (25) for controlling the scanning optical system (6, 8) and the light modulator (4);
a support structure (27) for carrying the photosensitive material.

9. Lithography exposure method, comprising:
providing a light beam at a first wavelength (λ₁);
scanning the light beam at the first wavelength (λ₁) and changing the optical intensity of the light at the first wavelength (λ₁), forming a spatially modulated pattern using a scanning optical system (6, 8);
converting the light output by the scanning optical system (6, 8) to light at a second wavelength (λ₂) which is shorter than the first wavelength (λ₁); and
imaging the light at the second wavelength (λ₂) onto a photosensitive material (12).

10. Lithography exposure method according to claim 9, further comprising:
imaging the light output by the scanning optical system (6, 8) onto a focal point, and
converting the scanned beam of light at the first wavelength (λ₁) to light at the second wavelength (λ₂) at the focal point.

11. Lithography exposure method according to any one of claims 9 or 10, wherein converting the scanned beam of light at the first wavelength (λ₁) to light at a second wavelength (λ₂) comprises generating a second or higher harmonic of the light at the first wavelength (λ₁).

12. Lithography exposure method according to any one of claims 9 or 10, wherein converting the scanned beam of light at the first wavelength (λ₁) to light at a second wavelength (λ₂) comprises generating a sum frequency of the light at the first wavelength (λ₁) and of light at a third wavelength (λ₃).

13. Lithography exposure method according to any one of claims 9 to 12, wherein spatially modulating the scanned beam of light comprises scanning of the beam by an acousto-optic modulator (4).
